# EUROPEAN PATENT APPLICATION

(11) **EP 4 797 921 A1**
(43) Date of publication of application: **26.08.2026**
(21) Application number: 24879964.5
(22) Date of filing: 12.09.2024
(51) Int. Cl.: H10K 59/131, H10K 59/121, H10K 77/10, H10K 59/80, H10K 59/12, H10K 71/60

(54) **DISPLAY DEVICE AND MANUFACTURING METHOD THEREFOR**

(30) Priority: 16.10.2023 KR 20230137836
(71) Applicant: Samsung Display Co., Ltd., Yongin-si, Gyeonggi-do 17113 (KR)
(72) Inventor: CHO, Yoon Jong, Yongin-Si Gyeonggi-do 17113 (KR); KIM, Hyun Su, Yongin-Si Gyeonggi-do 17113 (KR)
(74) Representative: Marks & Clerk LLP
(86) International application number: PCT/KR2024/013859
(87) International publication number: WO 2025/084625

(57) **Abstract**

The display device comprises: a first electrode provided in a first conductive layer on a substrate; a first insulating layer covering the first conductive layer; a second electrode provided in a second conductive layer on the first insulating layer; a second insulating layer covering the second conductive layer; an active layer of a transistor, provided in a semiconductor layer on the second insulating layer; a gate insulating layer arranged on a portion of the active layer; a third electrode provided in a third conductive layer on the gate insulating layer; a third insulating layer covering the semiconductor layer, the gate insulating layer, and the third conductive layer; and a fourth electrode provided in a fourth conductive layer on the third insulating layer. The fourth electrode overlaps the first electrode and is directly connected to the first electrode through a first contact hole which passes through the first insulating layer, the second insulating layer, and the third insulating layer.

## Description

### [Technical Field]

Embodiments of the present disclosure relate to a display device and a method for manufacturing the same.

### [Background Art]

The importance of display devices has steadily increased with the development of multimedia technology. In response to this, various display devices including light emitting display devices are being developed.

### [Detailed Description of the Invention]

### [Technical Problem]

The problem to be solved by the present disclosure is to provide a display device capable of improving manufacturing efficiency and a method for manufacturing the same.

The tasks of the present invention are not limited to the tasks mentioned above, and other technical tasks not mentioned will be clearly understood by those skilled in the art from the description below.

### [Technical Solution]

A display device according to an embodiment includes a first electrode provided in a first conductive layer on a substrate, a first insulating layer disposed on the substrate, and covering the first conductive layer, a second electrode provided in a second conductive layer on the first insulating layer, a second insulating layer disposed on the first insulating layer, and covering the second conductive layer, an active layer of a transistor provided in a semiconductor layer on the second insulating layer, a gate insulating layer disposed on the second insulating layer, and disposed on a part of the active layer, a third electrode provided in a third conductive layer on the gate insulating layer, a third insulating layer disposed on the second insulating layer, and covering the semiconductor layer, the gate insulating layer, and the third conductive layer, and a fourth electrode provided in a fourth conductive layer on the third insulating layer. The fourth electrode overlaps the first electrode and is directly connected to the first electrode through a first contact hole penetrating the first insulating layer, the second insulating layer, and the third insulating layer.

In an embodiment, the fourth electrode may be directly connected to the third electrode through a second contact hole penetrating the third insulating layer, and the first electrode, the third electrode, and the fourth electrode may constitute a first capacitor electrode of a capacitor.

In an embodiment, the second electrode may overlap at least one of the first electrode, the third electrode, or the fourth electrode and may constitute a second capacitor electrode of the capacitor.

In an embodiment, the display device may further include a fifth electrode provided in the fourth conductive layer while being spaced apart from the fourth electrode, and overlapping the second electrode. The fifth electrode may be directly connected to the second electrode through a third contact hole penetrating the second insulating layer and the third insulating layer and may constitute the second capacitor electrode.

In an embodiment, the display device may further include a fourth insulating layer disposed on the third insulating layer, and covering the fourth conductive layer, and a sixth electrode provided in a fifth conductive layer on the fourth insulating layer, and overlapping the fifth electrode. The sixth electrode may be connected to the fifth electrode through a fourth contact hole penetrating the fourth insulating layer and may constitute the second capacitor electrode.

In an embodiment, the transistor may further include a gate electrode provided in the third conductive layer and disposed on a part of the active layer.

In an embodiment, the transistor may further include at least one of, a source electrode provided in the fourth conductive layer and connected to a source region of the active layer through a fifth contact hole penetrating the third insulating layer, and a drain electrode provided in the fourth conductive layer and connected to a drain region of the active layer through a sixth contact hole penetrating the third insulating layer.

In an embodiment, the transistor may further include a bottom electrode provided in the second conductive layer and overlapping the active layer and the gate electrode.

In an embodiment, the bottom electrode may be connected to the source electrode through a seventh contact hole penetrating the second insulating layer and the third insulating layer.

In an embodiment, the display device may further include a fourth insulating layer disposed on the third insulating layer and covering the fourth conductive layer, a bridge electrode provided in a fifth conductive layer on the fourth insulating layer and connected to one of the source electrode and the drain electrode through an eighth contact hole penetrating the fourth insulating layer, and a fifth insulating layer disposed on the fourth insulating layer and covering the fifth conductive layer.

In an embodiment, the display device may further include a light emitting element layer disposed on the fifth insulating layer and including a light emitting element connected to the bridge electrode through a ninth contact hole penetrating the fifth insulating layer, and an encapsulation layer covering the light emitting element layer.

A display device according to an embodiment includes a capacitor including a first electrode provided in a first conductive layer on a substrate, a second electrode provided in a second conductive layer on the first conductive layer, a third electrode provided in a third conductive layer on the second conductive layer and a fourth electrode provided in a fourth conductive layer on the third conductive layer, a first insulating layer disposed between the first conductive layer and the second conductive layer, a second insulating layer disposed between the second conductive layer and the third conductive layer, and a third insulating layer disposed between the third conductive layer and the fourth conductive layer. The fourth electrode is directly connected to the first electrode through a first contact hole penetrating the first insulating layer, the second insulating layer, and the third insulating layer and is directly connected to the third electrode through a second contact hole penetrating the third insulating layer.

In an embodiment, the capacitor may further include a fifth electrode spaced apart from the fourth electrode, provided in the fourth conductive layer and overlapping the second electrode, and the fifth electrode may be directly connected to the second electrode through a third contact hole penetrating the second insulating layer and the third insulating layer.

In an embodiment, the display device may further a fourth insulating layer disposed on the third insulating layer and covering the fourth conductive layer, and a fifth conductive layer disposed on the fourth insulating layer. The capacitor may further include a sixth electrode provided in the fifth conductive layer and connected to the fifth electrode through a fourth contact hole penetrating the fourth insulating layer.

In an embodiment, the display device may further a semiconductor layer disposed between the second insulating layer and the third conductive layer, a gate insulating layer disposed between the semiconductor layer and the third conductive layer, and a transistor including an active layer provided in the semiconductor layer and a gate electrode provided in the third conductive layer and disposed on a part of the active layer.

In an embodiment, the gate insulating layer may be disposed between the part of the active layer and the gate electrode and may expose another part of the active layer.

A method for manufacturing a display device according to an embodiment includes forming a first conductive layer including a first electrode and a first insulating layer covering the first conductive layer, on a substrate, forming a second conductive layer including a second electrode and a second insulating layer covering the second conductive layer, on the first insulating layer, forming a semiconductor layer including an active layer of a transistor and a gate insulating layer covering the semiconductor layer, on the second insulating layer, forming a conductive film on the gate insulating layer, etching the conductive film and the gate insulating layer to form a first gate insulating layer and a gate electrode on a part of the active layer, and form a second gate insulating layer and a third electrode on a part of the second insulating layer, forming a third insulating layer covering the active layer, the gate electrode, and the third electrode, on the second insulating layer, forming a first contact hole penetrating the first insulating layer, the second insulating layer, and the third insulating layer to expose a part of the first electrode, and forming a fourth conductive layer including a fourth electrode directly connected to the first electrode through the first contact hole, on the third insulating layer.

In an embodiment, the forming of the first contact hole may include further forming a second contact hole penetrating the third insulating layer to expose a part of the third electrode, and the forming of the fourth conductive layer may include directly connecting the fourth electrode to the third electrode through the second contact hole.

In an embodiment, the forming of the first contact hole may include further forming a third contact hole penetrating the second insulating layer and the third insulating layer to expose a part of the second electrode, and the forming of the fourth conductive layer may include further forming a fifth electrode spaced apart from the fourth electrode and directly connected to the second electrode through the third contact hole.

In an embodiment, the forming of the first contact hole may include further forming a plurality of contact holes penetrating the third insulating layer to expose different parts of the active layer, and the forming of the fourth conductive layer may include further forming a source electrode and a drain electrode connected to different parts of the active layer through the plurality of contact holes.

Other details of the embodiments are included in the detailed description and the drawings.

### [Effects of the Invention]

A display device according to embodiments may include patterns provided in a first conductive layer, a second conductive layer, a third conductive layer, and a fourth conductive layer that are sequentially disposed on a substrate. The display device may further include an active layer provided in a semiconductor layer between the second conductive layer and the third conductive layer. In embodiments, the patterns provided in the conductive layers and/or the semiconductor layer under the fourth conductive layer may be connected individually and/or in parallel to the patterns provided in the fourth conductive layer through respective contact holes. In embodiments, the contact holes may be formed simultaneously by a single mask process.

In accordance with the display device and the method for manufacturing the same according to the embodiments, it is possible to efficiently utilize a pixel area of a display panel, and appropriately secure a design space for forming pixels and wires. Further, the number of mask processes used for manufacturing the display panel may be reduced and/or minimized, and the manufacturing process of the display panel may be simplified. Accordingly, the manufacturing cost of the display device may be reduced, and the manufacturing efficiency may be increased.

The effects according to the embodiments are not limited to the contents exampled above, and more diverse effects are included in the present disclosure.

### [Brief Description of the Drawings]

FIG. 1 is a plan view illustrating a display device according to one embodiment;
FIG. 2 is a plan view illustrating a display panel of FIG. 1;
FIG. 3 is an equivalent circuit diagram illustrating the pixel according to one embodiment;
FIG. 4 is a cross-sectional view illustrating the display panel according to one embodiment; and
FIGS. 5 to 15 are cross-sectional views showing a method for manufacturing the display device according to one embodiment.

### [Mode for Invention]

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being "on" another element or layer, the element or layer can be directly on another element or layer or intervening elements or layers. Like reference numerals refer to like elements throughout the specification. Shapes, sizes, ratios, angles, numbers, etc. disclosed in the drawings for describing embodiments are merely an example, and the present disclosure is not limited to the illustrated details.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, specific embodiments will be described with reference to the accompanying drawings.

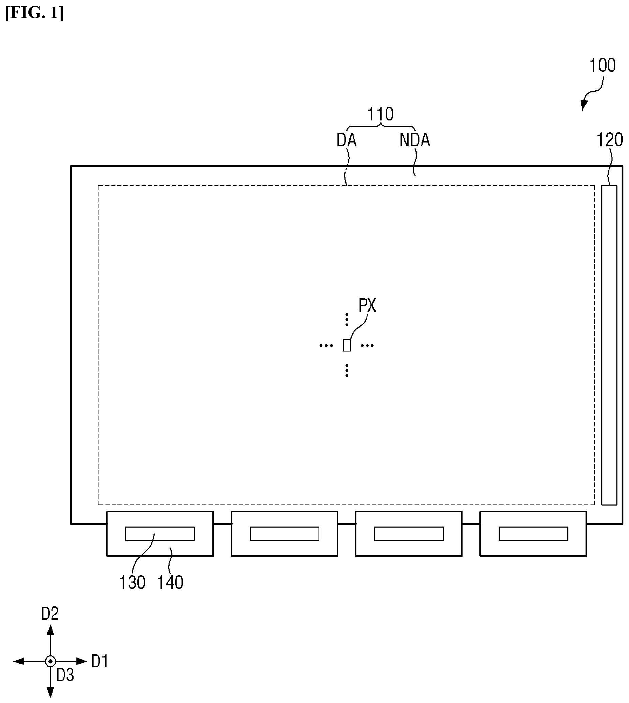

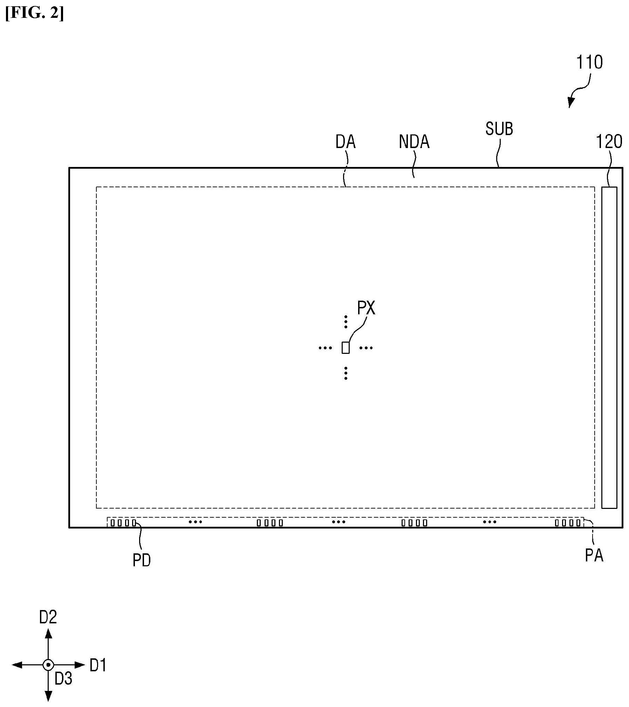

FIG. 1 is a plan view illustrating a display device 100 according to one embodiment. FIG. 2 is a plan view illustrating a display panel 110 of FIG. 1.

Referring to FIGS. 1 and 2, the display device 100 is a device for displaying a moving image or a still image. The display device 100 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC). These are presented as nothing more than examples, and the display device 100 may be applicable to various other types of electronic devices.

In one embodiment, the display device 100 may be a light emitting display device such as an organic light emitting display including an organic light emitting diode, a quantum dot light emitting display including a quantum dot light emitting layer, an inorganic light emitting display including an inorganic semiconductor, or an ultra-small light emitting display including an ultra-small light emitting diode such as a micro or nano light emitting diode (micro LED or nano LED), but is not limited thereto. For example, the display device 100 may be another type of display device other than a light emitting display device. In the following, embodiments in which the display device 100 is a light emitting display device (e.g., an organic light emitting display device) will be disclosed.

The display device 100 may include the display panel 110 including pixels PX, and a first driver 120 and a second driver 130 configured to supply driving signals to the pixels PX. The display device 100 may further include additional components. For example, the display device 100 may further include a power supply unit for supplying power voltages to the pixels PX, the first driver 120, and the second driver 130, and a timing controller for controlling the operations of the first driver 120 and the second driver 130.

The display panel 110 may include a display area DA and a non-display area NDA. The display area DA may be an area including the pixels PX to display an image. For example, the display area DA may include pixel areas where the pixels PX are arranged. The non-display area NDA is an area other than the display area DA, and an image may not be displayed in the non-display area NDA. In one embodiment, the non-display area NDA may be positioned around the display area DA and may surround the display area DA.

In FIGS. 1 and 2, a first direction D1, a second direction D2, and a third direction D3 are defined. In one embodiment, the first direction D1 may be the horizontal direction of the display panel 110, and the second direction D2 may be the vertical direction of the display panel 110. The third direction D3 may be a thickness direction of the display panel 110.

In one embodiment, the display panel 110 may have a rectangular shape in plan view. Although FIGS. 1 and 2 illustrate the display panel 110 with a horizontal length longer than a vertical length, the shape of the display panel 110 is not limited thereto. For example, the display panel 110 may have a shape in which the vertical length is longer than the horizontal length, or may have a square shape or the like. The display panel 110 may include angled corners or rounded corners.

The planar shape of the display panel 110 is not limited to the illustrated quadrilateral shape, and it may be applied in other shapes. For example, the display panel 110 may have a non-quadrilateral polygonal shape, a circular shape, an elliptical shape, an atypical shape, or another shape in plan view.

In one embodiment, the display panel 110 may be substantially flat on the plane defined by the first direction D1 and the second direction D2, and may have a uniform thickness in the third direction D3. Alternatively, the display panel 110 may be provided in a three-dimensional shape having a curved surface or the like.

The display panel 110 may be provided as a rigid panel so as not to be substantially transformed, or as a flexible panel that can be transformed to be at least partially folded, bent, or rolled. The display panel 110 may be provided to the display device 100 without bending, or may be provided to the display device 100 while being partially bent.

The display panel 110 may include a substrate SUB and pixels PX disposed on the substrate SUB. The pixels PX may be disposed in the display area DA on the substrate SUB.

The substrate SUB, which is a base member for manufacturing or providing the display panel 110, may form the base surface of the display panel 110. The substrate SUB may include the display area DA and the non-display area NDA around the display area DA.

The display area DA may have various shapes depending on embodiments. For example, the display area DA may have a quadrilateral shape, a non-quadrilateral polygonal shape, a circular shape, an elliptical shape, an atypical shape, or another shape. In one embodiment, the display area DA may have a shape conforming to the shape of the display panel 110.

The pixels PX may be provided and/or arranged in the display area DA. For example, the display area DA may include a plurality of pixel areas where the pixels PX are arranged.

In one embodiment, the display device 100 may be a light emitting display device, and each pixel PX may include a light emitting element located in each emission area and a pixel circuit connected to the light emitting element. In describing embodiments, the term "connect" may include electrical connection and/or physical connection. In addition, unless otherwise specified as "direct connection" or "indirect connection", the term "connection" may encompass both direct and indirect connections. Each pixel circuit may include transistors (e.g., transistors including a driving transistor that generates a driving current corresponding to a data signal, and at least one switching transistor) and at least one capacitor (e.g., a capacitor including a storage capacitor).

The non-display area NDA may include a pad area PA where pads PD are disposed. In one embodiment, the non-display area NDA may further include a driving circuit area located on at least one side of the display area DA. At least one driver, the pads PD, and/or wires may be disposed in the non-display area NDA.

At least one driver for driving the pixels PX, or a part of the driver may be disposed in the driving circuit area. For example, circuit elements (e.g., driving transistors and driving capacitors constituting stage circuits of the first driver 120) constituting the first driver 120 may be disposed in the driving circuit area on the substrate SUB. In one embodiment, the circuit elements of the first driver 120 may be formed in the display panel 110 together with the pixels PX. In one embodiment, the driving transistors provided in the first driver 120 may be transistors having a type and/or a structure that are substantially the same as or similar to those of the transistors provided in the pixels PX, and may be formed simultaneously with the transistors of the pixels PX.

The pads PD may be disposed in the pad area PA. At least one circuit board 140 may be disposed and/or bonded on the pad area PA. In one embodiment, a plurality of circuit boards 140 connected to different pads PD may be disposed on the pad area PA. The pads PD may include signal pads and power pads for transmitting driving signals and power voltages required for driving the pixels PX and/or the first driver 120 into the display panel 110.

The first driver 120 and the second driver 130 may generate driving signals for controlling operation timing, luminance, and the like of the pixels PX, and may supply the generated driving signals to the pixels PX. For example, the first driver 120 may be a gate driver including a scan driver, and may be connected to the pixels PX through respective gate lines. The first driver 120 may supply gate signals (e.g., control signals for controlling the driving timing of the pixels PX, including scan signals and/or emission control signals) to the pixels PX. The second driver 130 may be a data driver including source driving circuits, and may be connected to the pixels PX through respective data lines. The second driver 130 may supply respective data signals to the pixels PX.

In one embodiment, at least one first driver of the first driver 120 or the second driver 130, or a part of the at least one first driver may be embedded in the display panel 110. For example, the first driver 120 or a part of the first driver 120 may be disposed and/or formed in the non-display area NDA and disposed on the substrate SUB of the display panel 110.

Although FIG. 1 illustrates that the first driver 120 is formed on one side of the display area DA (for example, in the non-display area NDA on the right side of the display area DA), but the embodiments are not limited thereto. For example, the first driver 120 may be positioned only on the other side (e.g., the non-display area NDA on the left side of the display area DA) of the display area DA, or may be positioned on both sides (e.g., the non-display area NDA on the left side and right side of the display area DA) of the display area DA. Alternatively, a part of the first driver 120 may be located in the non-display area NDA, and the other part of the first driver 120 may be located in a non-emission area (e.g., an area between the emission areas of the pixels PX) in the display area DA.

In one embodiment, the other driver of the first driver 120 and the second driver 130 or a part of the other driver may be disposed or formed outside the display panel 110 to be electrically connected to the display panel 110. For example, the second driver 130 may be implemented as a plurality of integrated circuit chips, and may be disposed on the circuit boards 140 electrically connected to the pixels PX of the display panel 110. The second driver 130 may be implemented as at least one integrated circuit chip and mounted on the non-display area NDA of the display panel 110.

The circuit board 140 may be connected to the display panel 110 through the pads PD. In one embodiment, the circuit board 140 may be a flexible film such as a flexible printed circuit board (FPCB), a printed circuit board (PCB), or a chip on film (COF), but is not limited thereto. In one embodiment, the circuit board 140 may be connected to the timing controller and/or the power supply unit through another circuit board, connector, or the like.

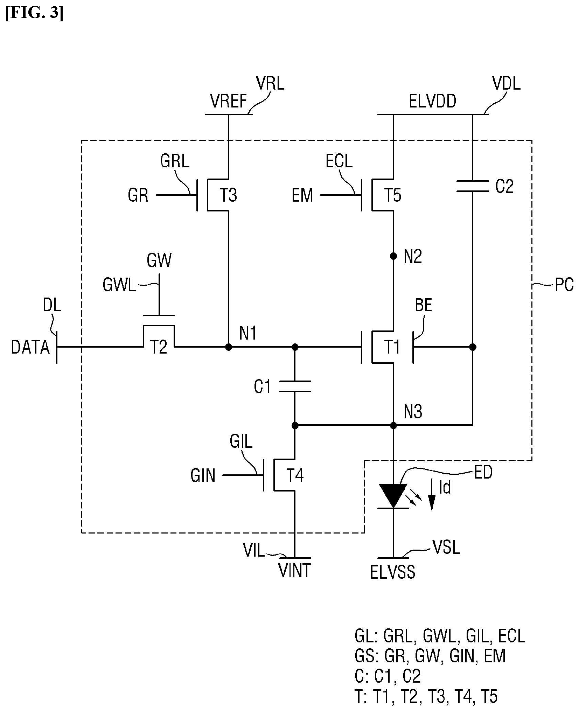

FIG. 3 is an equivalent circuit diagram illustrating the pixel PX according to one embodiment. For example, FIG. 3 shows the pixel PX of the light emitting display device including a light emitting element ED. In addition to the embodiment of FIG. 3, the type and/or structure of the pixel PX that may be included in the display device 100 may be variously changed depending on embodiments.

Referring to FIG. 3 in addition to FIGS. 1 and 2, the pixel PX may include the light emitting element ED, and a pixel circuit PC connected to (e.g., electrically connected to) the light emitting element ED. The light emitting element ED is a light source of the pixel PX, and it may be, for example, an organic light emitting diode, but is not limited thereto. The pixel circuit PC may control the emission time point and the luminance of the light emitting element ED.

The pixel circuit PC may include transistors T and at least one capacitor C. For example, the pixel circuit PC may include first to fifth transistors T1 to T5, and first and second capacitors C1 and C2. Although FIG. 3 shows an embodiment in which all the transistors T are N-type transistors, the types of the transistors T are not limited thereto. For example, at least one transistor T may be formed of a P-type transistor.

The pixel circuit PC may supply a driving current Id to the light emitting element ED in response to the driving signals supplied from the first driver 120 and the second driver 130. For example, the pixel circuit PC may supply the driving current Id to the light emitting element ED in response to respective gate signals GS supplied from the first driver 120 through respective gate lines GL and a data signal DATA supplied from the second driver 130 through a data line DL.

The first transistor T1 may be a driving transistor of the pixel PX whose magnitude of drain-source current (e.g., the driving current Id) is determined depending on the gate-source voltage. The second, third, fourth, and fifth transistors T2, T3, T4, and T5 may be switching transistors that are turned on or off depending on respective gate-source voltages. Depending on the type (for example, P-type or N-type) and/or operating conditions of each of the first to fifth transistors T1 to T5, a first electrode of each of the first to fifth transistors T1 to T5 may be a drain electrode (or a drain region), or a source electrode (or a source region), and a second electrode thereof may be an electrode different from the first electrode. For example, when the first electrode is a drain electrode, the second electrode may be a source electrode.

The pixel PX may be connected to a first gate line GWL that transmits a first gate signal GW (e.g., a scan signal), a second gate line GIL that transmits a second gate signal GIN, a third gate line GRL that transmits a third gate signal GR, an emission control line ECL that transmits an emission control signal EM, and the data line DL that transmits the data signal DATA. Further, the pixel PX may be connected to a first power line VDL that transmits a first pixel voltage ELVDD (also referred to as "first pixel power voltage"), and a second power line VSL that transmits a second pixel voltage ELVSS (also referred to as "second pixel power voltage"). In one embodiment, the pixel PX may be further connected to an initialization power line VIL that transmits an initialization voltage VINT (also referred to as "third pixel power voltage"), and a reference power line VRL that transmits a reference voltage VREF (also referred to as "fourth pixel power voltage").

In one embodiment, the first to fifth transistors T1 to T5 may be located in each pixel area, and may be oxide transistors (also referred to as "oxide semiconductor transistors") including an oxide semiconductor (e.g., an oxide semiconductor material). By way of example, an active layer of each of the first to fifth transistors T1 to T5 may include the oxide semiconductor. However, embodiments are not limited thereto. For example, at least one transistor T may be formed of a semiconductor material (for example, amorphous silicon or polysilicon) other than an oxide semiconductor.

The oxide semiconductor may have high carrier mobility and a low leakage current, so that a considerable voltage drop may not occur even if the driving time of the oxide transistor increases. For example, the pixel PX including an oxide transistor may be driven at a low frequency because the change in the luminance and/or the color of an image due to a voltage drop is not significant even when it is driven at a low frequency. When the first to fifth transistors T1 to T5 are formed of oxide transistors, the leakage current of the pixel PX may be reduced or prevented and the power consumption may be reduced.

The oxide semiconductor is sensitive to light, so that the amount of current or the like may be changed due to external light. In one embodiment, a light blocking pattern or a light blocking electrode (e.g., a bottom electrode or a back-gate electrode) may be disposed under the active layer included in at least one transistor T to block external light. Accordingly, the operating characteristics of the transistor T may be stabilized.

The first transistor T1 may include a gate electrode connected to a first node N1, a first electrode (for example, a drain electrode) connected to a second node N2, and a second electrode (for example, a source electrode) connected to a third node N3. The first electrode of the first transistor T1 may be connected to the first power line VDL via the fifth transistor T5, and the second electrode thereof may be connected to the light emitting element ED. The first transistor T1 may control the magnitude (e.g., current amount) of the driving current Id flowing to the light emitting element ED to correspond to the data signal DATA transmitted to the first node N1.

In one embodiment, the first transistor T1 may further include a bottom electrode BE (e.g., the bottom-gate electrode or the back-gate electrode of the first transistor T1) connected to the third node N3. When the first transistor T1 is formed of a transistor having a double gate structure (e.g., a double gate transistor having a source-sync structure) by connecting the bottom electrode BE of the first transistor T1 to the third node N3, the operating characteristics of the first transistor T1 may be improved.

The second transistor T2 may include a gate electrode connected to the first gate line GWL, a first electrode connected to the data line DL, and a second electrode connected to the first node N1. The second transistor T2 may be turned on by the first gate signal GW (for example, the first gate signal GW of the gate-on voltage) transmitted to the first gate line GWL to connect the data line DL and the first node N1. Accordingly, the data signal DATA transmitted through the data line DL may be sent to the first node N1.

The third transistor T3 may include a gate electrode connected to the third gate line GRL, a first electrode connected to the reference power line VRL, and a second electrode connected to the first node N1. The third transistor T3 may be turned on by the third gate signal GR transmitted through the third gate line GRL and transmit the reference voltage VREF transmitted to the reference power line VRL to the first node N1.

The fourth transistor T4 may include a gate electrode connected to the second gate line GIL, a first electrode connected to the third node N3, and a second electrode connected to the initialization power line VIL. The fourth transistor T4 may be turned on by the second gate signal GIN transmitted through the second gate line GIL and transmit the initialization voltage VINT transmitted to the initialization power line VIL to the third node N3.

The fifth transistor T5 may include a gate electrode connected to the emission control line ECL, a first electrode connected to the first power line VDL, and a second electrode connected to the second node (or the first electrode of the first transistor T1). The fifth transistor T5 may be turned on by the emission control signal EM (for example, the emission control signal EM of the gate-on voltage) transmitted to the emission control line ECL to control the emission time point of the pixel PX.

Each of the second to fifth transistors T2 to T5 may or may not include the bottom electrode. In one embodiment, at least one switching transistor among the second to fifth transistors T2 to T5 may include the bottom electrode, and the bottom electrode of the at least one switching transistor may be connected to the gate electrode of the corresponding switching transistor. When the bottom electrode of the switching transistor is connected to the gate electrode, it is possible to improve the off characteristics and the switching speed of the switching transistor, secure an additional voltage tolerance range, lower a leakage current, and improve voltage stability. For example, since a switching transistor formed of an oxide transistor with a short channel length is formed in a double gate structure such as a gate-sync structure or the like, the operating characteristics of the switching transistor may be improved.

The first capacitor C1 may be connected between the first node N1 and the third node N3. The first capacitor C1 is a storage capacitor of the pixel PX, and may store therein a threshold voltage of the first transistor T1 and a voltage corresponding to the data signal DATA (e.g., a data voltage).

The second capacitor C2 may be connected between the first power line VDL and the third node N3. In one embodiment, the capacitance of the second capacitor C2 may be less than that of the first capacitor C1.

The light emitting element ED may be connected between the third node N3 and the second power line VSL. For example, the light emitting element ED may include a first electrode (e.g., an anode electrode) connected to the third node N3, a second electrode (e.g., a cathode electrode) facing the first electrode and connected to the second power line VSL, and a light emitting layer disposed between the first electrode and the second electrode. In one embodiment, the first electrode of the light emitting element ED may be an individual electrode individually provided in each pixel PX, and the second electrode of the light emitting element ED may be a common electrode shared by a plurality of pixels PX. The light emitting element ED may emit light with a luminance corresponding to the driving current Id during a time period in which the driving current Id is supplied from the pixel circuit PC.

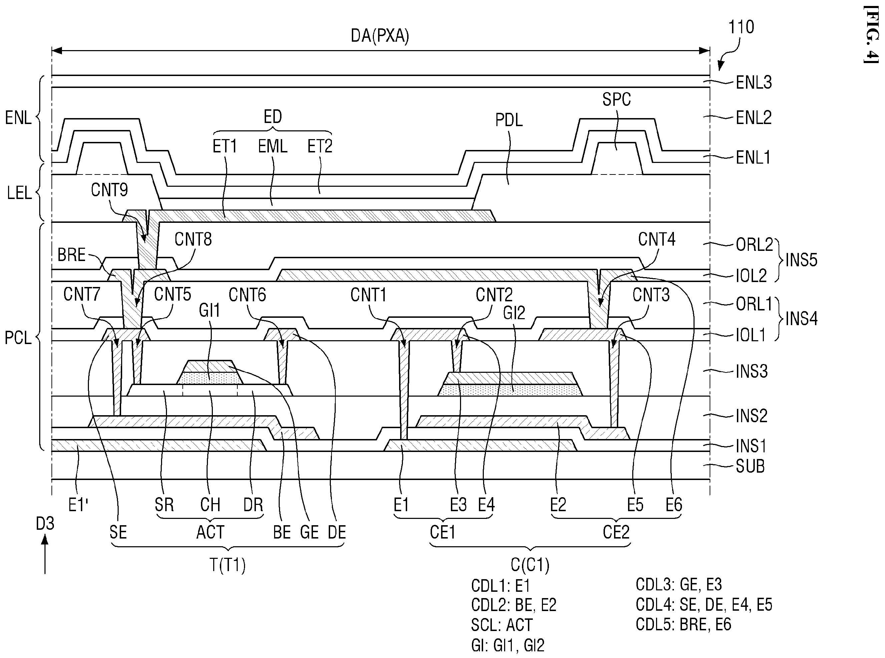

FIG. 4 is a cross-sectional view illustrating the display panel 110 according to one embodiment. For example, FIG. 4 shows a part of the display area DA of the display panel 110. FIG. 4 illustrates a light emitting display panel including the light emitting element ED (for example, an organic light emitting diode) as an example of the display panel 110 to which embodiments may be applied.

Referring to FIG. 4 in addition to FIGS. 1 to 3, the display panel 110 may include the substrate SUB (also referred to as "base layer"), the panel circuit layer PCL, a light emitting element layer LEL, and an encapsulation layer ENL. The panel circuit layer PCL, the light emitting element layer LEL, and the encapsulation layer ENL may be disposed to overlap each other on the substrate SUB. For example, with respect to the display area DA, the panel circuit layer PCL, the light emitting element layer LEL, and the encapsulation layer ENL may be sequentially disposed on the substrate SUB along the third direction D3. However, the embodiments are not limited thereto, and the positions of the panel circuit layer PCL, the light emitting element layer LEL, and/or the encapsulation layer ENL may be changed.

In one embodiment, the display panel 110 may further include additional elements disposed above and/or under the encapsulation layer ENL. For example, the display panel 110 may further include at least one of a sensor layer (for example, a touch sensor layer), an optical layer (for example, a color filter layer and/or a wavelength conversion layer), or a passivation layer (for example, a passivation film, an insulating layer, an upper substrate, and/or a window). Each of the sensor layer, the optical layer, and/or the passivation layer may be disposed above the encapsulation layer ENL or may be disposed between the light emitting element layer LEL and the encapsulation layer ENL.

The substrate SUB, which is a base member for forming the display panel 110, may be a rigid or flexible substrate (or film). In one embodiment, the substrate SUB may be a substrate including an insulating material such as glass or the like and having rigid characteristics, and may not be bent. Alternatively, the substrate SUB may be a flexible substrate that includes polyimide or another insulating material and may be transformed to be bent, folded, or rolled, and may or may not be bent. The type and/or material of the substrate SUB may change depending on embodiments.

In one embodiment, the display panel 110 may selectively further include a barrier layer (e.g., an inorganic insulating layer capable of blocking moisture permeation) disposed between the substrate SUB and the panel circuit layer PCL. For example, the barrier layer may be disposed on the substrate SUB and the panel circuit layer PCL may be disposed on the barrier layer, or the panel circuit layer PCL may be directly disposed on the substrate SUB without the barrier layer.

The panel circuit layer PCL may include circuit elements including the transistors T and the capacitors C of the pixels PX, and wires (e.g., signal lines and power lines). In one embodiment, the panel circuit layer PCL may further include circuit elements (e.g., driving transistors and/or driving capacitors included in the first driver 120) of the first driver 120, and/or additional conductive patterns (e.g., bridge patterns).

FIG. 4 shows one transistor T and one capacitor C disposed in any one pixel area PXA, as an example of the circuit elements that may be provided in the panel circuit layer PCL (e.g., circuit elements that may be included in the panel circuit layer PCL). The transistor T of FIG. 4 may be a driving transistor or a switching transistor provided in (e.g., included in) the pixel circuit PC of the corresponding pixel PX. For example, the transistor T of FIG. 4 may be the first transistor T1 of FIG. 3. The capacitor C of FIG. 4 may be any one capacitor C provided in (e.g., included in) the pixel circuit PC of the corresponding pixel PX. For example, the capacitor C of FIG. 4 may be the first capacitor C1 of FIG. 3. In describing the embodiments, when a certain element is said to be "provided in" another element, it may mean that the certain element is included in or disposed inside the other element.

The panel circuit layer PCL may include conductive layers and a semiconductor layer SCL including circuit elements, wires, and the like. The electrodes constituting the circuit elements (e.g., the transistors T and the capacitors C) of the panel circuit layer PCL, and the conductive patterns (e.g., bridge electrodes BRE and/or wires) connected to the electrodes and/or the wires may be provided in the conductive layers. The active layers ACT of the transistors T provided in the panel circuit layer PCL may be provided in the semiconductor layer SCL.

In one embodiment, the panel circuit layer PCL may include a first conductive layer CDL1 (also referred to as "first lower conductive layer" or "first bottom conductive layer"), a second conductive layer CDL2 (also referred to as "second lower conductive layer" or "second bottom conductive layer"), the semiconductor layer SCL, a third conductive layer CDL3 (also referred to as "gate conductive layer"), and a fourth conductive layer CDL4 (also referred to as "first source-drain conductive layer" or "first data conductive layer") that are sequentially disposed on the substrate SUB along the third direction D3. In one embodiment, the panel circuit layer PCL may further include a fifth conductive layer CDL5 (also referred to as "second source-drain conductive layer" or "second data conductive layer") disposed on the fourth conductive layer CDL4.

The respective electrodes, conductive patterns, and/or wires provided in the conductive layers (e.g., included in the conductive layers) of the panel circuit layer PCL may include at least one conductive material. For example, the electrodes, the conductive patterns, and/or the wires provided in each of the first conductive layer CDL1, the second conductive layer CDL2, the third conductive layer CDL3, the fourth conductive layer CDL4, and the fifth conductive layer CDL5 may include at least one of copper (Cu), titanium (Ti), molybdenum (Mo), aluminium (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), or another metal, an alloy thereof, or another conductive material. In one embodiment, the electrodes, the conductive patterns, and/or the wires disposed on the same conductive layer may be simultaneously formed using the same conductive material.

In one embodiment, the electrodes, the conductive patterns, and/or the wire provided in the conductive layers of the panel circuit layer PCL may have a single-layer or multi-layer structure. For example, the electrodes, the conductive patterns, and/or the wires provided in the first conductive layer CDL1, the second conductive layer CDL2, the third conductive layer CDL3, the fourth conductive layer CDL4, and the fifth conductive layer CDL5 may have a single-layer or multi-layer structure.

The panel circuit layer PCL may further include a plurality of insulating layers and/or insulating patterns disposed on the substrate SUB. For example, the panel circuit layer PCL may include a first insulating layer INS1, a second insulating layer INS2, a gate insulating layer GI, a third insulating layer INS3, a fourth insulating layer INS4, and a fifth insulating layer INS5 that are sequentially disposed on the substrate SUB along the third direction D3.

The first insulating layer INS1 may be disposed between the first conductive layer CDL1 and the second conductive layer CDL2, and may cover the first conductive layer CDL1. For example, the first insulating layer INS1 may be disposed on the substrate SUB, and may cover the patterns of the first conductive layer CDL1, e.g., the electrodes, the wires, and/or the conductive patterns provided in the first conductive layer CDL1.

The second insulating layer INS2 may be disposed between the second conductive layer CDL2 and the semiconductor layer SCL, and may cover the second conductive layer CDL2. For example, the second insulating layer INS2 may be disposed on the first insulating layer INS1, and may cover the patterns of the second conductive layer CDL2, e.g., the electrodes, the wires, and/or the conductive patterns provided in the second conductive layer CDL2.

The gate insulating layer GI may be disposed on the second insulating layer INS2 and the semiconductor layer SCL. For example, the gate insulating layer GI may be disposed between the second insulating layer INS2 and the semiconductor layer SCL and the third conductive layer CDL3. The gate insulating layer GI may cover at least a part of the second insulating layer INS2 and at least a part of the semiconductor layer SCL.

The third insulating layer INS3 may be disposed on the second insulating layer INS2. For example, the third insulating layer INS3 may be disposed between the third conductive layer CDL3 and the fourth conductive layer CDL4. The third insulating layer INS3 may cover the semiconductor layer SCL, the gate insulating layer GI, and the third conductive layer CDL3. For example, the third insulating layer INS3 may cover the patterns of the semiconductor layer SCL, the gate insulating layer GI and the third conductive layer CDL3, e.g., the active layers ACT provided in the semiconductor layer SCL, the insulating patterns (e.g., a first gate insulating layer GI1 and a second gate insulating layer GI2 that are integrated with each other or separated from each other) provided in the gate insulating layer GI, and the electrodes, the wires, and/or the conductive patterns provided in the third conductive layer CDL3.

The fourth insulating layer INS4 may be disposed between the fourth conductive layer CDL4 and the fifth conductive layer CDL5, and may cover the fourth conductive layer CDL4. For example, the fourth insulating layer INS4 may be disposed on the third insulating layer INS3, and may cover the patterns of the fourth conductive layer CDL4, e.g., the electrodes, the wires, and/or the conductive patterns provided in the fourth conductive layer CDL4.

In one embodiment, the fourth insulating layer INS4 may have a multi-layer structure including an inorganic insulating layer and an organic insulating layer. For example, the fourth insulating layer INS4 may include a first inorganic layer IOL1 and a first organic layer ORL1 that are sequentially disposed on the third insulating layer INS3.

The fifth insulating layer INS5 may be disposed between the fifth conductive layer CDL5 and the light emitting element layer LEL, and may cover the fifth conductive layer CDL5. For example, the fifth insulating layer INS5 may be disposed on the fourth insulating layer INS4, and may cover the patterns of the fifth conductive layer CDL5, e.g., the electrodes, the wires, and/or the conductive patterns provided in the fifth conductive layer CDL5.

In one embodiment, the fifth insulating layer INS5 may have a multi-layer structure including an inorganic insulating layer and an organic insulating layer. For example, the fifth insulating layer INS5 may include a second inorganic layer IOL2 and a second organic layer ORL2 sequentially disposed on the fourth insulating layer INS4.

In one embodiment, each of the first insulating layer INS1, the second insulating layer INS2, the gate insulating layer GI, the third insulating layer INS3, the first inorganic layer IOL1, and the second inorganic layer IOL2 may include at least one inorganic insulating layer containing an inorganic insulating material (e.g., silicon nitride, silicon oxide, silicon oxynitride, titanium oxide, aluminium oxide, or another inorganic insulating material). For example, each of the first insulating layer INS1, the second insulating layer INS2, the gate insulating layer GI, the third insulating layer INS3, the first inorganic layer IOL1, and the second inorganic layer IOL2 may be a single-layer or multi-layer inorganic insulating layer.

In one embodiment, each of the first organic layer ORL1 and the second organic layer ORL2 may include at least one organic insulating layer containing an organic insulating material (e.g., acrylic resin, epoxy resin, phenolic resin, polyamide resin, polyimide resin, or another organic insulating material). The surfaces (e.g., top surfaces) of the first organic layer ORL1 and the second organic layer ORL2 may be substantially flat.

In one embodiment, at least one insulating layer included in the panel circuit layer PCL may be disposed entirely in the display area DA. For example, the first insulating layer INS1, the second insulating layer INS2, the third insulating layer INS3, the fourth insulating layer INS4, and the fifth insulating layer INS5 may be disposed entirely in the display area DA.

In one embodiment, the gate insulating layer GI may be partially disposed only in each pixel area PXA and a part of the display area DA including the same. In one embodiment, the gate insulating layer GI may include the first gate insulating layer GI1 (also referred to as "first gate insulating pattern") disposed on a part of each active layer ACT provided in the semiconductor layer SCL, and the second gate insulating layer GI2 (also referred to as "second gate insulating pattern") disposed on the second insulating layer INS2 without overlapping the active layer ACT. For example, the first gate insulating layer GI1 may be disposed between a part of the active layer ACT including a channel region CH and the gate electrode GE, and the second gate insulating layer GI2 may be disposed between a third electrode E3 of the capacitor C provided in the third conductive layer CDL3 and the second insulating layer INS2. The first gate insulating layer GI1 and the second gate insulating layer GI2 may be connected to each other to form an integrated insulating pattern, or may be individual insulating patterns that are separated from each other in plan view. However, embodiments are not limited thereto. For example, the gate insulating layer GI may be disposed entirely in the display area DA to entirely cover the second insulating layer INS2 and the semiconductor layer SCL.

The transistor T may include the active layer ACT (also referred to as "active pattern" or "semiconductor pattern") and the gate electrode GE (e.g., a top-gate electrode) disposed on a part of the active layer ACT. In one embodiment, the transistor T may further include at least one of a source electrode SE or a drain electrode DE. For example, the transistor T may further include the source electrode SE connected to a source region SR of the active layer ACT and the drain electrode DE connected to a drain region DR of the active layer ACT. Alternatively, the transistor T may not include a separate source electrode and/or a separate drain electrode, and the source region SR and/or the drain region DR of the first active layer ACT may be connected to another circuit element, wire, and/or conductive pattern to function as the source electrode and/or the drain electrode of the transistor T.

In one embodiment, the transistor T may further include the bottom electrode BE (e.g., the bottom-gate electrode) disposed under the active layer ACT. In one embodiment, the bottom electrode BE may be connected to one electrode of the transistor T, and may be utilized as the back-gate electrode for adjusting the characteristics of the transistor T. Since the bottom electrode BE is disposed under the active layer ACT, it is possible to block external light from being incident on the channel region CH of the active layer ACT, and stabilize the operating characteristics of the transistor T.

In one embodiment, the transistor T may be an N-type transistor. For example, the transistor T may be an N-type oxide transistor.

The bottom electrode BE may be provided in the second conductive layer CDL2. For example, the second conductive layer CDL2 includes the bottom electrode BE and may optionally further include additional conductive patterns. The second conductive layer CDL2 may be disposed between the first insulating layer INS1 and the second insulating layer INS2. The bottom electrode BE may overlap the active layer ACT and the gate electrode GE. For example, the bottom electrode BE may be disposed under the active layer ACT to overlap at least a part of the active layer ACT including the channel region CH, and may face the gate electrode GE with the active layer ACT interposed therebetween.

In one embodiment, the bottom electrode BE may be connected to the source electrode SE or the gate electrode GE of the transistor T. For example, the transistor T may be the driving transistor of the pixel PX, and the bottom electrode BE of the transistor T may be connected to the source electrode SE of the transistor T through a seventh contact hole CNT7 penetrating the second insulating layer INS2 and the third insulating layer INS3. Alternatively, the transistor T may be the switching transistor of the pixel PX, and the bottom electrode BE of the transistor T may be connected to the gate electrode GE of the transistor T.

The active layer ACT may be provided in the semiconductor layer SCL. For example, the semiconductor layer SCL includes the active layer ACT and may optionally further include additional semiconductor patterns. The semiconductor layer SCL may be disposed on the second insulating layer INS2 covering the second conductive layer CDL2, and may be covered by the gate insulating layer GI and the third insulating layer INS3.

The active layer ACT may include the channel region CH, and the source region SR and the drain region DR spaced apart from each other with the channel region CH interposed therebetween. For example, the source region SR and the drain region DR may be located on both sides of the channel region CH. The channel region CH may be a region that maintains semiconductor characteristics without becoming conductive. The source region SR and the drain region DR, which are regions that have become conductive, may have a carrier concentration (for example, electron concentration) higher than that of the channel region CH.

The active layer ACT may overlap the bottom electrode BE and the gate electrode GE. For example, a part of the active layer ACT including the channel region CH may overlap the bottom electrode BE and the gate electrode GE.

In one embodiment, the active layer ACT may include an oxide semiconductor. For example, the active layer ACT may include an oxide semiconductor containing at least one of indium (In), gallium (Ga), zinc (Zn), tin (Sn), and hafnium (Hf), or other oxide semiconductors. In one embodiment, the active layer ACT may include at least one of zinc oxide (ZnO), zinc-tin oxide (ZTO), indium-zinc oxide (IZO), indium oxide (InO or In₂O₃), titanium oxide (TiO or TiO₂), indium-gallium oxide (IGO), indium-gallium-zinc oxide (IGZO), indium-gallium-tin oxide (IGTO), indium-zinc-tin oxide (IZTO), and indium-tin-gallium-zinc oxide (ITGZO), or other oxide semiconductors.

In one embodiment, the active layer ACT may be formed of a high-mobility oxide semiconductor (for example, an oxide semiconductor material with mobility of approximately 20 cm²/Vs or 30 cm²/Vs or more). For example, the active layer ACT may be formed of indium-gallium-zinc oxide (IGZO) or indium-tin-gallium-zinc oxide (ITGZO), and may have mobility of approximately 20 cm²/Vs or higher. When the active layer ACT is formed of a high-mobility oxide semiconductor, the conductivity of the source region SR and the drain region DR may be appropriately and/or easily secured without performing an additional doping process. Further, when the active layer ACT is formed of a high-mobility oxide semiconductor, it is possible to form the transistor T in a fine size (e.g., a size including the active layer ACT having a width and/or length within a range of approximately several micrometers to several tens of micrometers) and appropriately secure the mobility of the transistor T.

The first gate insulating layer GI1 may be disposed on the active layer ACT. In one embodiment, the first gate insulating layer GI1 may be disposed only on a part of the active layer ACT, and may not be disposed on the other part of the active layer ACT. For example, the first gate insulating layer GI1 may be disposed on a part of the active layer ACT including the channel region CH, and may expose the source region SR and the drain region DR of the active layer ACT.

Since the first gate insulating layer GI1 exposes the source region SR and the drain region DR, the source region SR and the drain region DR may become appropriately and/or easily conductive in the manufacturing process of the display panel 110. For example, in the step of etching the gate insulating layer GI to expose at least a part of the source region SR and at least a part of the drain region DR, oxygen vacancies may occur in the source region SR and the drain region DR by an etching gas or the like. Accordingly, the source region SR and the drain region DR may become appropriately conductive in a subsequent process (e.g., a process of forming the third insulating layer INS3) without performing a separate doping process.

In one embodiment, in order to limit the carrier concentration of the source region SR and the drain region DR and/or the mobility of the active layer ACT to an appropriate range, an oxygen supply layer may be formed between the first gate insulating layer GI1 and the gate electrode GE. For example, the transistor T may further include the oxygen supply layer disposed between the first gate insulating layer GI1 and the gate electrode GE and containing an oxide semiconductor. The active layer ACT and the oxygen supply layer of the transistor T may contain the same oxide semiconductor or different oxide semiconductors.

A gate electrode GE may be disposed on the first gate insulating layer GI1. The gate electrode GE may be provided in the third conductive layer CDL3. For example, the third conductive layer CDL3 includes the gate electrode GE and may optionally further include additional conductive patterns. The third conductive layer CDL3 may be disposed on the second insulating layer INS2 and the gate insulating layer GI, and may be covered by the third insulating layer INS3.

The gate electrode GE may be disposed on the active layer ACT to overlap the channel region CH. The gate electrode GE and the active layer ACT may be separated and/or spaced apart from each other with the first gate insulating layer GI1 interposed therebetween.

The third insulating layer INS3 may be disposed on the gate electrode GE. The third insulating layer INS3 may cover the active layer ACT, the gate insulating layer GI, and the gate electrode GE.

The source electrode SE and the drain electrode DE may be disposed on the third insulating layer INS3. The source electrode SE and the drain electrode DE may be provided in the fourth conductive layer CDL4. For example, the fourth conductive layer CDL4 includes the source electrode SE and the drain electrode DE and may optionally further include additional conductive patterns. The fourth conductive layer CDL4 may be disposed between the third insulating layer INS3 and the fourth insulating layer INS4.

The source electrode SE may be connected to a part of the active layer ACT. For example, the source electrode SE may be connected to the source region SR of the active layer ACT through a fifth contact hole CNT5 penetrating the third insulating layer INS3. In one embodiment, the source electrode SE may be further connected to the bottom electrode BE through the seventh contact hole CNT7 penetrating the second insulating layer INS2 and the third insulating layer INS3.

The drain electrode DE may be connected to another part of the active layer ACT. For example, the drain electrode DE may be connected to the drain region DR of the active layer ACT through a sixth contact hole CNT6 penetrating the third insulating layer INS3.

In one embodiment, at least one transistor T disposed in each pixel area PXA may be connected to the bridge electrode BRE disposed on the fourth insulating layer INS4 covering the fourth conductive layer CDL4, and may be connected to the light emitting element ED of the corresponding pixel PX through the bridge electrode BRE. For example, the source electrode SE (or the drain electrode DE) of the first transistor T1 disposed in each pixel area PXA may be connected to the bridge electrode BRE on the fourth insulating layer INS4 through an eighth contact hole CNT8 penetrating the fourth insulating layer INS4.

The bridge electrode BRE may be provided in the fifth conductive layer CDL5. For example, the fifth conductive layer CDL5 includes the bridge electrode BRE and may optionally further include additional conductive patterns. The fifth conductive layer CDL5 may be disposed between the fourth insulating layer INS4 and the fifth insulating layer INS5. For example, the fifth conductive layer CDL5 may be disposed on the fourth insulating layer INS4 and covered by the fifth insulating layer INS5. The bridge electrode BRE may be connected to a first electrode ET1 of the light emitting element ED provided in the light emitting element layer LEL through a ninth contact hole CNT9 penetrating the fifth insulating layer INS5.

The capacitor C may include a first capacitor electrode CE1 and a second capacitor electrode CE2 forming a capacitance. In one embodiment, the capacitor C may have a multi-layer structure including multi-layer electrodes (or sub-electrodes). Accordingly, the capacitance of the capacitor C may be secured by efficiently utilizing the area of the pixel area PXA. For example, in the high-resolution display panel 110 in which the area of the pixel area PXA is relatively small, at least one of the first capacitor electrode CE1 or the second capacitor electrode CE2 is formed of a multi-layer electrode, so that the capacitance of the capacitor C may be appropriately secured while reducing the area occupied by the capacitor C.

In embodiments, the capacitor C may include a first electrode E1 provided in the first conductive layer CDL1, a second electrode E2 provided in the second conductive layer CDL2, the third electrode E3 provided in the third conductive layer CDL3, a fourth electrode E4 provided in the fourth conductive layer CDL4. For example, the first conductive layer CDL1, the second conductive layer CDL2, the third conductive layer CDL3 and the fourth conductive layer CDL4 may include the first electrode E1, the second electrode E2, the third electrode E3 and the fourth electrode E4, respectively. In one embodiment, the capacitor C may further include at least one of a fifth electrode E5 provided in the fourth conductive layer CDL4 while being spaced apart from the fourth electrode E4, or a sixth electrode E6 provided in the fifth conductive layer CDL5. For example, the fourth conductive layer CDL4 and the fifth conductive layer CDL5 may include the fifth electrode E5 and the sixth electrode E6, respectively.

In embodiments, the fourth electrode E4 may overlap the first electrode E1, and may be directly connected to the first electrode E1 through a first contact hole CNT1 penetrating the first insulating layer INS1, the second insulating layer INS2, and the third insulating layer INS3. In one embodiment, the fourth electrode E4 may overlap the third electrode E3, and may be directly connected to the third electrode E3 through a second contact hole CNT2 penetrating the third insulating layer INS3. For example, the fourth electrode E4 may be connected individually and/or in parallel to the first electrode E1 and the third electrode E3 through the first contact hole CNT1 and the second contact hole CNT2, respectively. In one embodiment, the first electrode E1 and the third electrode E3 may be connected to each other through the fourth electrode E4, and may not be directly connected to each other. The first electrode E1, the third electrode E3, and the fourth electrode E4 may form the first capacitor electrode CE1 of the capacitor C.

In one embodiment, a part E1' of the first electrode E1 may overlap the transistor T. For example, in FIG. 4, the first electrode E1 under the fourth electrode E4 and the first electrode E1' under the active layer ACT, which are connected to form an integrated electrode in plan view, may be different parts of the integrated electrode. However, embodiments are not limited thereto. For example, the first electrode E1 located in a capacitor area and constituting the first capacitor electrode CE1, and another electrode, wire, and/or conductive pattern located in a transistor area and separated from the first electrode E1 may be provided in the first conductive layer CDL1.

In one embodiment, the third electrode E3 may be connected to the gate electrode GE of the first transistor T1 located in each pixel area PXA. For example, the third electrode E3 may be provided in the third conductive layer CDL3 integrally with the gate electrode GE of the first transistor T1. For example, the third electrode E3 and the gate electrode GE of the first transistor T1 may be connected to each other to form an integrated electrode in plan view. In this case, the first gate insulating layer GI1 located under the gate electrode GE of the first transistor T1 and the second gate insulating layer GI2 located under the third electrode E3 may be connected to each other to form an integrated insulating pattern.

The second electrode E2 may overlap at least one of the first electrode E1, the third electrode E3, or the fourth electrode E4 and may form a capacitance between itself and the at least one electrode. The second electrode E2 may constitute the second capacitor electrode CE2.

In one embodiment, the second electrode E2 may be connected to the source electrode SE of the first transistor T1 located in each pixel area PXA. For example, the second electrode E2 may be provided in the second conductive layer CDL2 integrally with the bottom electrode BE of the first transistor T1, and may be connected to the source electrode SE of the first transistor T1 through the seventh contact hole CNT7.

The fifth electrode E5 may overlap the second electrode E2, and may be directly connected to the second electrode E2 through a third contact hole CNT3 penetrating the second insulating layer INS2 and the third insulating layer INS3. The fifth electrode E5 may constitute the second capacitor electrode CE2 together with the second electrode E2. The fifth electrode E5 may be formed integrally with the source electrode SE of the first transistor T1 located in each pixel area PXA, or may be formed separately from the source electrode SE.

The sixth electrode E6 may overlap the fifth electrode E5, and may be connected (e.g., directly connected) to the fifth electrode E5 through a fourth contact hole CNT4 penetrating the fourth insulating layer INS4. The sixth electrode E6 may constitute the second capacitor electrode CE2 together with the second electrode E2 and the fifth electrode E5. The sixth electrode E6 may be formed integrally with the bridge electrode BRE located in each pixel area PXA, or may be formed separately from the bridge electrode BRE.

In one embodiment, the display panel 110 may include multi-layer wires including sub-wires provided in at least two conductive layers provided in the panel circuit layer PCL, similarly to the first capacitor electrode CE1 and/or the second capacitor electrode CE2. For example, at least one of the wires provided in the display panel 110 (e.g., the wires formed in the display panel 110) may have a multi-layer structure including at least two sub-wires among a first sub-wire provided in the first conductive layer CDL1, a second sub-wire provided in the second conductive layer CDL2, a third sub-wire provided in the third conductive layer CDL3, a fourth sub-wire provided in the fourth conductive layer CDL4, and a fifth sub-wire provided in the fifth conductive layer CDL5. In one embodiment, the multi-layer wires may include at least one sub-wire among the first, second, third, and fifth sub-wires, and the fourth sub-wire. In one embodiment, the fourth sub-wire may be directly connected to the first, second and/or third sub-wires through at least one contact hole penetrating at least the third insulating layer INS3, or may be connected to the fifth sub-wire through a contact hole penetrating the fourth insulating layer INS4. In one embodiment, the first, second and/or third sub-wires may not be directly connected to each other.

The light emitting element layer LEL may be disposed on the panel circuit layer PCL. For example, the light emitting element layer LEL may be disposed on the fifth insulating layer INS5, and may be located at least in the display area DA.

The light emitting element layer LEL may include the light emitting element ED for each of the pixels PX. For example, the light emitting element layer LEL may include a pixel defining layer PDL (also referred to as "bank") that partitions the emission areas of the pixels PX and the light emitting element ED located in each emission area. In one embodiment, the light emitting element layer LEL may further include a spacer SPC disposed on a part of the pixel defining layer PDL.

Each light emitting element ED may include the first electrode ET1 located in each emission area, and a light emitting layer EML and the second electrode ET2 that are sequentially disposed on the first electrode ET1. The first electrode ET1 of the light emitting element ED may be connected to at least one transistor (e.g., the first transistor T1) included in the corresponding pixel PX.

The first electrode ET1 of the light emitting element ED may be a single-layer or multi-layer electrode containing at least one conductive material. In one embodiment, the display panel 110 may be a front emitting display panel, and the first electrode ET1 may include a reflective electrode layer having high reflectivity.

The light emitting layer EML of the light emitting element ED may include a polymer material or a low molecular material. Light emitted from the light emitting layer EML may contribute to image display.

The second electrode ET2 of the light emitting element ED may include a conductive material. In one embodiment, the second electrode ET2 may be a common layer formed across the entire display area DA to cover the light emitting layer EML and the pixel defining layer PDL. In one embodiment, the display panel 110 may be a front emitting display panel, and the second electrode ET2 may include a transparent or translucent electrode layer.

The pixel defining layer PDL may have an opening corresponding to each emission area and may surround the emission area. For example, the pixel defining layer PDL may be formed to cover an edge of the first electrode ET1 of the light emitting element ED and may include an opening exposing the remaining portion of the first electrode ET1. A region where the exposed first electrode ET1 and the light emitting layer EML overlap may be the emission area of each pixel PX. In one embodiment, the pixel defining layer PDL may include at least one organic insulating layer containing an organic insulating material.

The spacer SPC may be disposed on a part of the pixel defining layer PDL. The spacer SPC may include at least one organic insulating layer containing an organic insulating material. The spacer SPC may include the same material as the pixel defining layer PDL or may include a different material from the pixel defining layer PDL. The pixel defining layer PDL and the spacer SPC may be sequentially formed by respective mask processes, or may be formed simultaneously and/or integrally using a halftone mask.

The encapsulation layer ENL may be disposed on the light emitting element layer LEL. The encapsulation layer ENL may cover the light emitting element layer LEL in the display area DA and may extend to the non-display area NDA to be in contact with the panel circuit layer PCL. The encapsulation layer ENL may block the permeation of oxygen or moisture into the light emitting element layer LEL, and may reduce electrical and/or physical impacts to the panel circuit layer PCL and the light emitting element layer LEL.

In one embodiment, the encapsulation layer ENL may include a first encapsulation layer ENL1, a second encapsulation layer ENL2, and a third encapsulation layer ENL3 sequentially disposed on the light emitting element layer LEL. Each of the first encapsulation layer ENL1 and the third encapsulation layer ENL3 may be an inorganic encapsulation layer containing an inorganic material. The second encapsulation layer ENL2 may be an organic encapsulation layer containing an organic material.

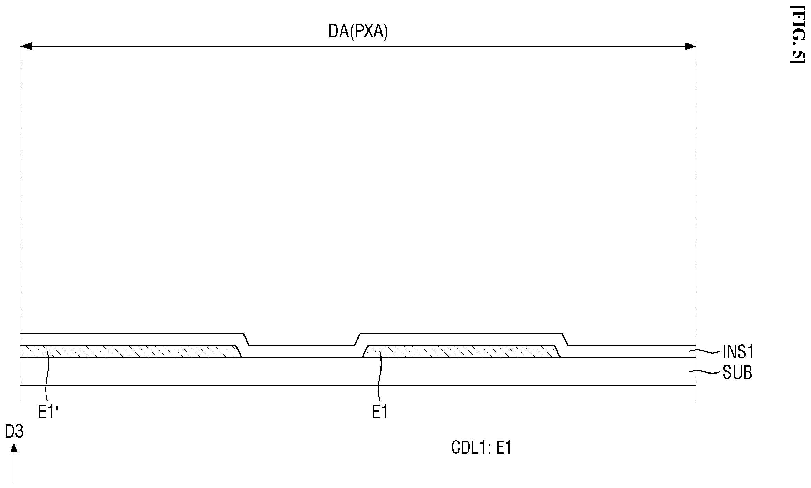

FIGS. 5 to 15 are cross-sectional views showing a method for manufacturing the display device 100 according to one embodiment. For example, FIGS. 5 to 15 sequentially show steps of forming the panel circuit layer PCL including the transistor T and the capacitor C among the steps of manufacturing the display panel 110 of FIG. 4.

Referring to FIG. 5 in addition to FIGS. 1 to 4, the substrate SUB including at least the display area DA may be prepared. The display area DA may include the pixel area PXA.

Then, the first conductive layer CDL1 including the first electrode E1 may be formed on the substrate SUB. The patterns (e.g., electrodes, conductive patterns, and/or at least one wire provided in the first conductive layer CDL1) of the first conductive layer CDL1 including the first electrode E1 may be formed by a film forming process (e.g., a deposition process) of a conductive film using at least one conductive material exemplified above and a patterning process (e.g., an etching process using a mask) of the conductive layer.

Thereafter, the first insulating layer INS1 covering the first conductive layer CDL1 may be formed on the substrate SUB. The first insulating layer INS1 may be formed by a film forming process of an insulating layer using at least one insulating material (for example, an inorganic insulating material) exemplified above.

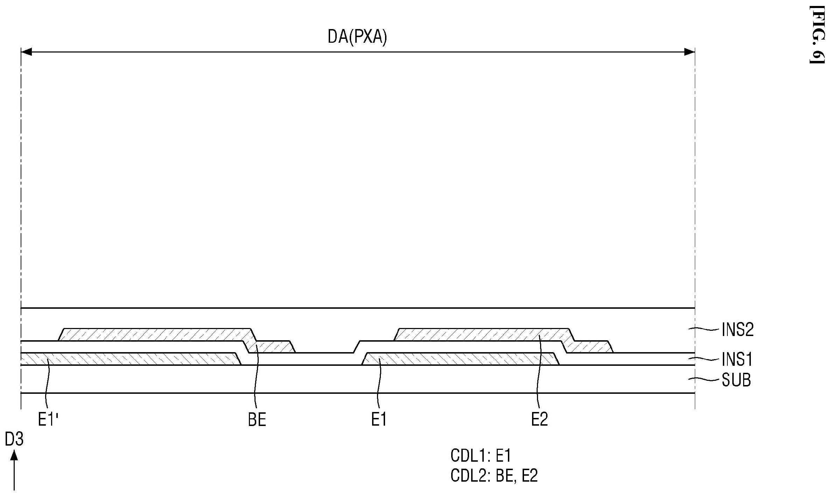

Referring to FIG. 6 in addition to FIGS. 1 to 5, the second conductive layer CDL2 including the bottom electrode BE and the second electrode E2 may be formed on the first insulating layer INS1. The patterns (e.g., electrodes, conductive patterns, and/or at least one wire provided in the second conductive layer CDL2) of the second conductive layer CDL2 including the bottom electrode BE and the second electrode E2 may be formed by a film forming process (e.g., a deposition process) of a conductive film using at least one conductive material exemplified above and a patterning process (e.g., an etching process using a mask) of the conductive layer.

Then, the second insulating layer INS2 covering the second conductive layer CDL2 may be formed on the first insulating layer INS1. The second insulating layer INS2 may be formed by a film forming process of an insulating layer using at least one insulating material (for example, an inorganic insulating material) exemplified above.

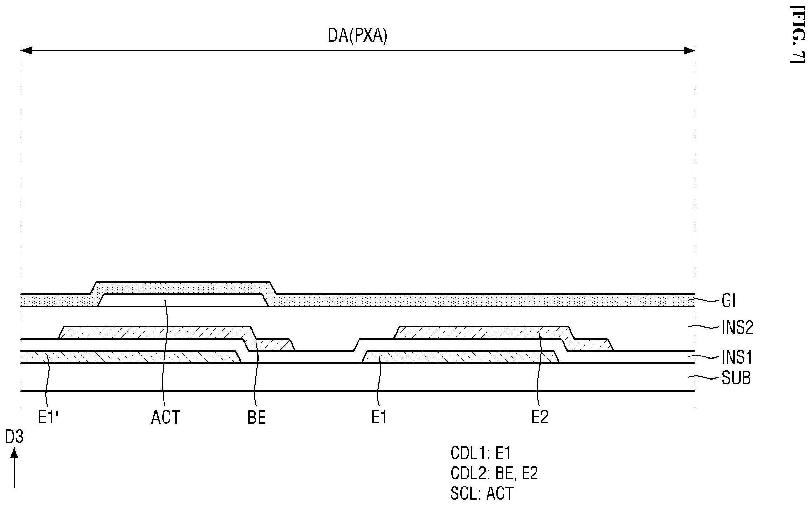

Referring to FIG. 7 in addition to FIGS. 1 to 6, the semiconductor layer SCL including the active layer ACT may be formed on the second insulating layer INS2. For example, the active layer ACT may be formed in each transistor region on the second insulating layer INS2.

The active layer ACT of the transistor T including the bottom electrode BE may be formed to overlap the bottom electrode BE. In one embodiment, the active layer ACT may be formed of an oxide semiconductor. For example, the active layer ACT may be formed by a film forming process and a patterning process (e.g., an etching process using a mask) of a semiconductor layer using at least one oxide semiconductor exemplified above.

Then, the gate insulating layer GI covering the semiconductor layer SCL may be formed on the second insulating layer INS2. The gate insulating layer GI may first be formed entirely on the substrate SUB including the display area DA and the like. The gate insulating layer GI may be formed by a film forming process of an insulating layer using at least one insulating material (for example, an inorganic insulating material such as silicon oxide) exemplified above.

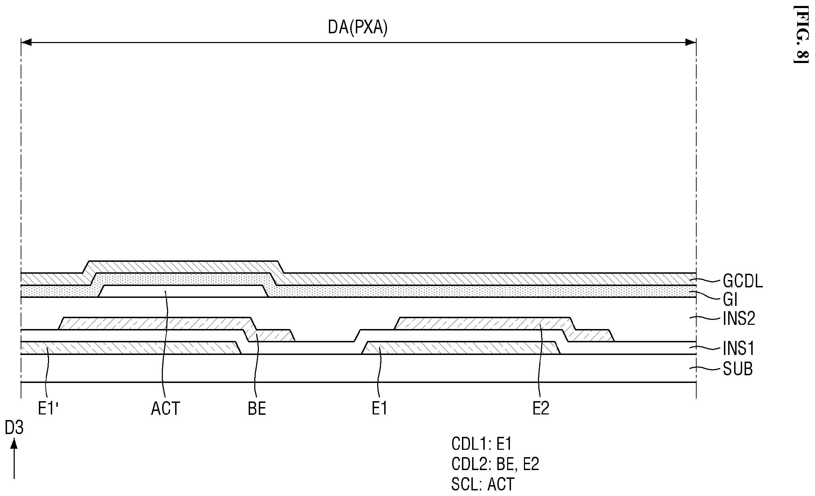

Referring to FIG. 8 in addition to FIGS. 1 to 7, a conductive film GCDL may be formed on the gate insulating layer GI. The conductive film GCDL for forming the third conductive layer CDL3 of FIG. 4 may first be formed entirely in the display area DA. For example, the conductive film GCDL may be formed entirely on the gate insulating layer GI. The conductive film GCDL may be formed by the film forming process of the conductive film using at least one conductive material exemplified above.

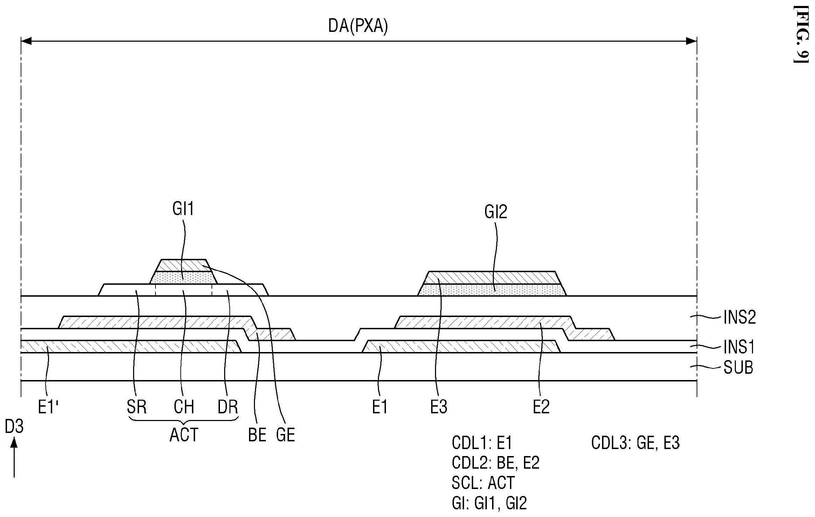

Referring to FIG. 9 in addition to FIGS. 1 to 8, the third conductive layer CDL3 including the gate electrode GE and the third electrode E3 may be formed by a patterning process of the conductive film GCDL. For example, the patterns (e.g., electrodes, conductive patterns, and/or at least one wire provided in the third conductive layer CDL3) of the third conductive layer CDL3 including the gate electrode GE and the third electrode E3 may be formed by an etching process using a mask.

In one embodiment, a patterning process for the gate insulating layer GI may also be performed to form the patterns (e.g., insulating patterns including the first gate insulating layer GI1 and the second gate insulating layer GI2) of the gate insulating layer GI. In one embodiment, the gate insulating layer GI may be etched by utilizing the mask used in the etching process of the third conductive layer CDL3 or by utilizing the third conductive layer CDL3 as a mask. For example, a mask having a shape corresponding to that of the third conductive layer CDL3 may be disposed on the conductive film GCDL, and the conductive film GCDL and the gate insulating layer GI may be sequentially and/or continuously etched using the mask. Accordingly, the gate insulating layer GI may be patterned in a shape corresponding to that of the third conductive layer CDL3. For example, the first gate insulating layer GI1 and the gate electrode GE may be formed on a part of the active layer ACT, and the second gate insulating layer GI2 and the third electrode E3 may be formed on a part of the second insulating layer INS2 where the active layer ACT is not disposed.

In the process of etching the gate insulating layer GI, the properties of the active layer ACT may be changed so that parts of the active layer ACT have different characteristics. Accordingly, the active layer ACT may be divided into a plurality of regions having different characteristics.

For example, mainly at a portion that does not overlap the gate electrode GE and the first gate insulating layer GI1, oxygen vacancies may occur in the oxide semiconductor forming the active layer ACT due to an etching gas or the like. Accordingly, the active layer ACT may be divided into a plurality of regions (for example, the channel region CH, the source region SR, and the drain region DR) having different characteristics. In one embodiment, oxygen vacancies may occur mainly at a portion (e.g., the source region SR and the drain region DR) of the active layer ACT that does not overlap the gate electrode GE and the first gate insulating layer GI1, and may spread to a part of the area overlapping the gate electrode GE and/or the first gate insulating layer GI1.

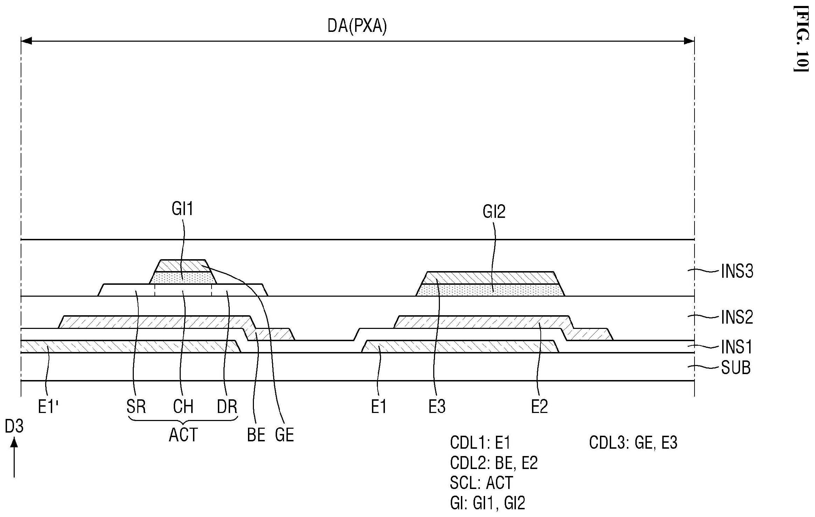

Referring to FIG. 10 in addition to FIGS. 1 to 9, the third insulating layer INS3 covering the semiconductor layer SCL, the gate insulating layer GI, and the third conductive layer CDL3 may be formed on the second insulating layer INS2. For example, the third insulating layer INS3 may be formed on the third conductive layer CDL3 to cover the active layer ACT, the first and second gate insulating layers GI1 and GI2, the gate electrode GE, and the third electrode E3. The third insulating layer INS3 may be formed by a film forming process of an insulating layer using at least one insulating material (for example, an inorganic insulating material) exemplified above.

Hydrogen may flow into the active layer ACT in the process of forming the third insulating layer INS3 and/or the heat treatment process before and after the process. Since hydrogen flows into the active layer ACT, a part of the active layer ACT may become conductive (e.g., conductive to N type) mainly at a portion containing a large number of oxygen vacancies. For example, the source region SR and the drain region DR may become conductive.

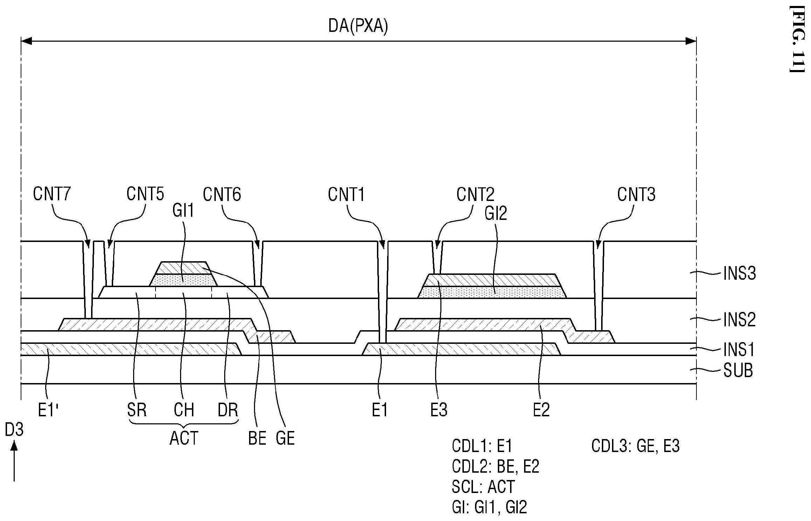

Referring to FIG. 11 in addition to FIGS. 1 to 10, a plurality of contact holes including the first contact hole CNT1 may be formed in at least the third insulating layer INS3. For example, the first, second, third, fifth, sixth, and seventh contact holes CNT1, CNT2, CNT3, CNT5, CNT6, and CNT7 may be formed by an etching process using a mask. The first contact hole CNT1 may be formed to penetrate the first insulating layer INS1, the second insulating layer INS2, and the third insulating layer INS3 and may expose a part of the first electrode E1. The second contact hole CNT2 may be formed to penetrate the third insulating layer INS3 and may expose a part of the third electrode E3. The third contact hole CNT3 may be formed to penetrate the second insulating layer INS2 and the third insulating layer INS3 and may expose a part of the second electrode E2. The fifth contact hole CNT5 may be formed to penetrate the third insulating layer INS3 and may expose a part of the active layer ACT, for example, a part of the source region SR. The sixth contact hole CNT6 may be formed to penetrate the third insulating layer INS3 and may expose another part of the active layer ACT, for example, a part of the drain region DR. The seventh contact hole CNT7 may be formed to penetrate the second insulating layer INS2 and the third insulating layer INS3 and may expose a part of the bottom electrode BE. In one embodiment, the first, second, third, fifth, sixth, and seventh contact holes CNT1, CNT2, CNT3, CNT5, CNT6, and CNT7 may be formed substantially simultaneously by a single mask process.

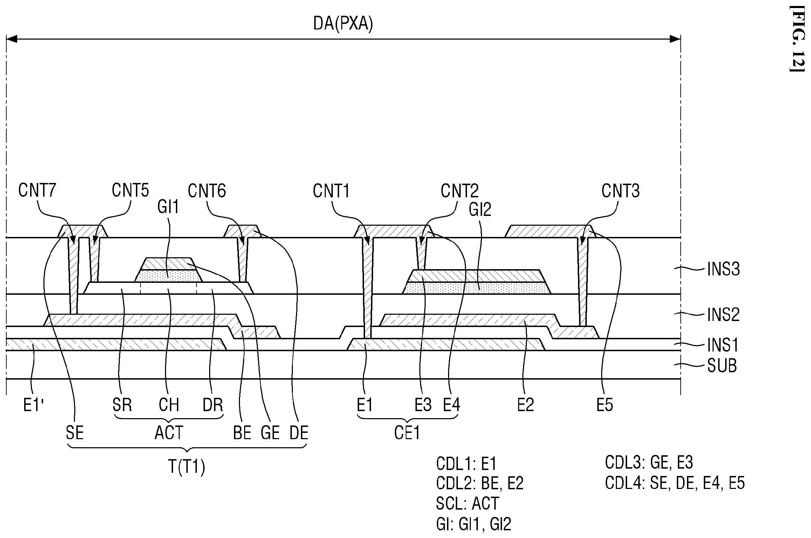

Referring to FIG. 12 in addition to FIGS. 1 to 11, the fourth conductive layer CDL4 including the source electrode SE, the drain electrode DE, the fourth electrode E4, and the fifth electrode E5 may be formed on the third insulating layer INS3. In one embodiment, when at least one of the source region SR or the drain region DR replaces at least one of the source electrode SE or the drain electrode DE, at least one of the source electrode SE or the drain electrode DE may not be formed.

The patterns (e.g., the electrodes, the conductive patterns, and/or the wires provided in the fourth conductive layer CDL4) of the fourth conductive layer CDL4 including the source electrode SE, the drain electrode DE, the fourth electrode E4, and/or the fifth electrode E5 may be formed by a film forming process (e.g., a deposition process) of a conductive film using at least one conductive material exemplified above and a patterning process (e.g., an etching process using a mask) of the conductive layer.

The source electrode SE may be formed to be connected to the source region SR through the fifth contact hole CNT5. In one embodiment, the source electrode SE of the first transistor T1 may be formed to be connected to the bottom electrode BE through the seventh contact hole CNT7. The drain electrode DE may be formed to be connected to the drain region DR through the sixth contact hole CNT6. The fourth electrode E4 may be formed to be connected to the first electrode E1 through the first contact hole CNT1 and may be formed to be connected to the third electrode E3 through the second contact hole CNT2. For example, the fourth electrode E4 may be formed to be directly connected to the first electrode E1 through the first contact hole CNT1 penetrating the first, second, and third insulating layers INS1, INS2, and INS3 at once, and may be formed to be directly connected to the third electrode E3 through the second contact hole CNT2 penetrating the third insulating layer INS3. The fifth electrode E5 may be formed to be spaced apart from the fourth electrode E4, and may be formed to be connected to the second electrode E2 through the third contact hole CNT3. For example, the fifth electrode E5 may be formed to be directly connected to the second electrode E2 through the third contact hole CNT3 penetrating the second and third insulating layers INS2 and INS3 at once.

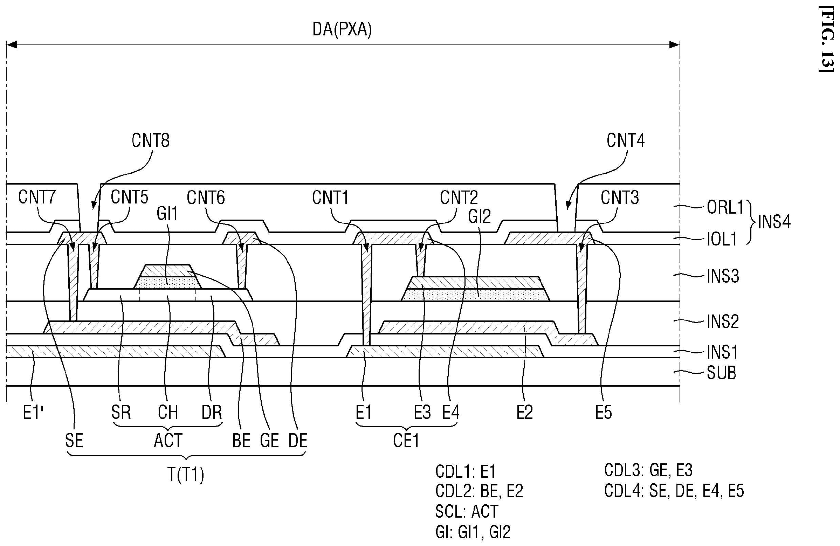

Referring to FIG. 13 in addition to FIGS. 1 to 12, the fourth insulating layer INS4 covering the fourth conductive layer CDL4 may be formed on the third insulating layer INS3. For example, the first inorganic layer IOL1 covering the fourth conductive layer CDL4, and the first organic layer ORL1 covering the first inorganic layer IOL1 may be sequentially formed on the third insulating layer INS3. The first inorganic layer IOL1 may be formed by a film forming process of an insulating layer using at least one inorganic insulating material exemplified above. The first organic layer ORL1 may be formed by a film forming process of an insulating layer using at least one organic insulating material exemplified above.

Then, a plurality of contact holes may be formed in the fourth insulating layer INS4. For example, the fourth contact hole CNT4 and the eighth contact hole CNT8 may be formed by an etching process using a mask. The fourth contact hole CNT4 may be formed to penetrate the first inorganic layer IOL1 and the first organic layer ORL1 and may expose a part of the fifth electrode E5. The eighth contact hole CNT8 may be formed to penetrate the first inorganic layer IOL1 and the first organic layer ORL1 and may expose a part of the source electrode SE of at least one transistor T1 (e.g., the first transistor T1) formed in each pixel area PXA. In one embodiment, the fourth contact hole CNT4 and the eighth contact hole CNT8 may be formed substantially simultaneously by a single mask process.

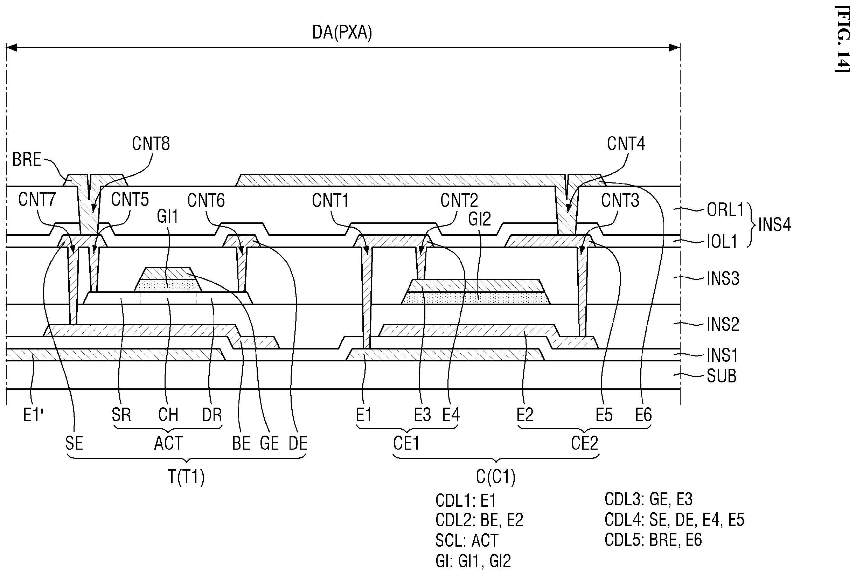

Referring to FIG. 14 in addition to FIGS. 1 to 13, the fifth conductive layer CDL5 including the bridge electrode BRE and the sixth electrode E6 may be formed on the fourth insulating layer INS4. In one embodiment, when the second capacitor electrode CE2 does not include the sixth electrode E6, the sixth electrode E6 may not be formed.

The patterns (e.g., the electrodes, the conductive patterns, and/or at least one wire provided in the fifth conductive layer CDL5) of the fifth conductive layer CDL5 including the bridge electrode BRE and/or the sixth electrode E6 may be formed by a film forming process (e.g., a deposition process) of a conductive film using at least one conductive material exemplified above and a patterning process (e.g., an etching process using a mask) of the conductive film.

The bridge electrode BRE may be formed to be connected to the source electrode SE of the first transistor T1 through the eighth contact hole CNT8. The sixth electrode E6 may be formed to be connected to the fifth electrode E5 through the fourth contact hole CNT4.

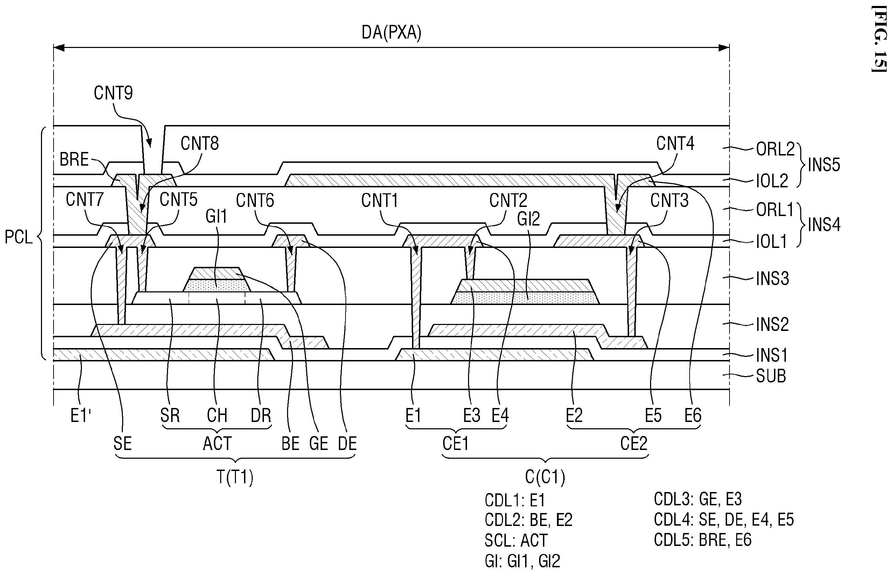

Referring to FIG. 15 in addition to FIGS. 1 to 14, the fifth insulating layer INS5 covering the fifth conductive layer CDL5 may be formed on the fourth insulating layer INS4. For example, the second inorganic layer IOL2 covering the fifth conductive layer CDL5, and the second organic layer ORL2 covering the second inorganic layer IOL2 may be sequentially formed on the fourth insulating layer INS4. The second inorganic layer IOL2 may be formed by a film forming process of an insulating layer using at least one inorganic insulating material exemplified above. The second organic layer ORL2 may be formed by a film forming process of an insulating layer using at least one organic insulating material exemplified above.

Then, a plurality of contact holes may be formed in the fifth insulating layer INS5. For example, the ninth contact hole CNT9 may be formed in each pixel area PXA by an etching process using a mask. The ninth contact hole CNT9 may be formed to penetrate the second inorganic layer IOL2 and the second organic layer ORL2 and may expose a part of the bridge electrode BRE.

Through the above-described processes, the panel circuit layer PCL of the display panel 110 may be formed. In one embodiment, when the panel circuit layer PCL does not include the fifth conductive layer CDL5 and the fifth insulating layer INS5, the step of forming the fifth conductive layer CDL5 and the fifth insulating layer INS5 may be omitted.

In one embodiment, when the display panel 110 includes the light emitting element layer LEL and the encapsulation layer ENL disposed on the panel circuit layer PCL as in the embodiment of FIG. 4, the light emitting element layer LEL and the encapsulation layer ENL may be sequentially formed on the panel circuit layer PCL. Through the above-described processes, the display panel 110 and the display device 100 including the same according to the embodiments may be manufactured.

As described above, in accordance with the display device 100 and the method for manufacturing the same according to embodiments, the display panel 110 may include the capacitor C having a multi-layer structure including the first electrode E1, the second electrode E2, the third electrode E3, and the fourth electrode E4 respectively provided in the first conductive layer CDL1, the second conductive layer CDL2, the third conductive layer CDL3, and the fourth conductive layer CDL4. Accordingly, the capacitance of the capacitor C may be sufficiently and/or appropriately secured while reducing the area of the capacitor C. Further, by efficiently utilizing the limited pixel area PXA, it is possible to secure an appropriate design space for forming the pixels PX and wires.

In embodiments, the first conductive layer CDL1 and the second conductive layer CDL2 may be lower conductive layers (e.g., lower conductive layers of the panel circuit layer PCL) located below the semiconductor layer SCL where the active layer ACT of the transistor T is provided, and the third conductive layer CDL3 and the fourth conductive layer CDL4 may be upper conductive layers located above the semiconductor layer SCL. In embodiments, the first electrode E1, the third electrode E3, and the fourth electrode E4 may constitute the multi-layer first capacitor electrode CE1, and the first electrode E1 and the third electrode E3 may be connected individually and/or in parallel to the fourth electrode E4 through the first contact hole CNT1 and the second contact hole CNT2, respectively. In one embodiment, the capacitor C may further include the fifth electrode E5 provided in the fourth conductive layer CDL4, and the fifth electrode E5 may be directly connected to the second electrode E2 and constitute the second capacitor electrode CE2 together with the second electrode E2. In one embodiment, the display panel 110 may further include the fifth conductive layer CDL5 on the fourth conductive layer CDL4, and the second capacitor electrode CE2 may further include the sixth electrode E6 provided in the fifth conductive layer CDL5 and connected to the fifth electrode E5. In one embodiment, the resistance of the wire may be reduced by designing a multi-layer wire on the panel circuit layer PCL in a structure and/or a connection method that are substantially the same as or similar to those of the first capacitor electrode CE1 and/or the second capacitor electrode CE2. In one embodiment, the active layer ACT of the transistor T provided in the semiconductor layer SCL may be directly connected to the source electrode SE and/or the drain electrode DE provided in the fourth conductive layer CDL4 through respective contact holes penetrating the third insulating layer INS3.

In accordance with embodiments, the patterns provided in the conductive layers under the fourth conductive layer CDL4 and the semiconductor layer SCL may be connected individually and/or in parallel to the patterns provided in the fourth conductive layer CDL4. For example, the electrodes, the conductive patterns and/or the wires provided in the first, second and third conductive layers CDL1, CDL2, and CDL3, and/or the active layer ACT provided in the semiconductor layer SCL may be connected individually and/or in parallel to the electrodes, the conductive patterns, and/or the wires provided in the fourth conductive layer CDL4. Accordingly, the number of mask processes used for manufacturing the display panel 110 may be reduced and/or minimized, and the manufacturing process of the display panel 110 may be simplified. Accordingly, it is possible to reduce the manufacturing cost of the display device 100 and increase the manufacturing efficiency thereof.

In addition, in embodiments, the bridge pattern may not be formed on the conductive layers under the fourth conductive layer CDL4, for example, the third conductive layer CDL3 and the like. For example, in order to utilize at least one pattern provided in the third conductive layer CDL3 as the bridge pattern, the area may be expanded, or a separate bridge pattern may not be formed on the third conductive layer CDL3. Accordingly, the design space for the electrodes, the conductive patterns, and/or the wires disposed on the third conductive layer CDL3 may be sufficiently secured.

Although the embodiments of the present invention have been described with reference to the attached drawings, those skilled in the art will understand that the present invention can be implemented in other specific forms without changing the technical idea or essential features of the present invention. Therefore, it should be understood that the embodiments described above are examples in all respects and not restrictive.

## Claims

1. A display device comprising:
a first electrode provided in a first conductive layer on a substrate;
a first insulating layer disposed on the substrate, and covering the first conductive layer;
a second electrode provided in a second conductive layer on the first insulating layer;
a second insulating layer disposed on the first insulating layer, and covering the second conductive layer;
an active layer of a transistor provided in a semiconductor layer on the second insulating layer;
a gate insulating layer disposed on the second insulating layer, and disposed on a part of the active layer;
a third electrode provided in a third conductive layer on the gate insulating layer;
a third insulating layer disposed on the second insulating layer, and covering the semiconductor layer, the gate insulating layer, and the third conductive layer; and
a fourth electrode provided in a fourth conductive layer on the third insulating layer,
wherein the fourth electrode overlaps the first electrode, and is directly connected to the first electrode through a first contact hole penetrating the first insulating layer, the second insulating layer, and the third insulating layer.

2. The display device of claim 1, wherein the fourth electrode is directly connected to the third electrode through a second contact hole penetrating the third insulating layer, and
the first electrode, the third electrode, and the fourth electrode constitute a first capacitor electrode of a capacitor.

3. The display device of claim 2, wherein the second electrode overlaps at least one of the first electrode, the third electrode, or the fourth electrode, and constitutes a second capacitor electrode of the capacitor.

4. The display device of claim 3, further comprising a fifth electrode provided in the fourth conductive layer while being spaced apart from the fourth electrode, and overlapping the second electrode,
wherein the fifth electrode is directly connected to the second electrode through a third contact hole penetrating the second insulating layer and the third insulating layer, and constitutes the second capacitor electrode.

5. The display device of claim 4, further comprising:
a fourth insulating layer disposed on the third insulating layer, and covering the fourth conductive layer; and
a sixth electrode provided in a fifth conductive layer on the fourth insulating layer, and overlapping the fifth electrode,
wherein the sixth electrode is connected to the fifth electrode through a fourth contact hole penetrating the fourth insulating layer, and constitutes the second capacitor electrode.

6. The display device of claim 1, wherein the transistor further comprises a gate electrode provided in the third conductive layer and disposed on a part of the active layer.

7. The display device of claim 6, wherein the transistor further comprises at least one of:
a source electrode provided in the fourth conductive layer, and connected to a source region of the active layer through a fifth contact hole penetrating the third insulating layer; and
a drain electrode provided in the fourth conductive layer, and connected to a drain region of the active layer through a sixth contact hole penetrating the third insulating layer.

8. The display device of claim 7, wherein the transistor further comprises a bottom electrode provided in the second conductive layer and overlapping the active layer and the gate electrode.

9. The display device of claim 8, wherein the bottom electrode is connected to the source electrode through a seventh contact hole penetrating the second insulating layer and the third insulating layer.

10. The display device of claim 7, further comprising:
a fourth insulating layer disposed on the third insulating layer, and covering the fourth conductive layer;
a bridge electrode provided in a fifth conductive layer on the fourth insulating layer, and connected to one of the source electrode and the drain electrode through an eighth contact hole penetrating the fourth insulating layer; and
a fifth insulating layer disposed on the fourth insulating layer, and covering the fifth conductive layer.

11. The display device of claim 10, further comprising:
a light emitting element layer disposed on the fifth insulating layer, and comprising a light emitting element connected to the bridge electrode through a ninth contact hole penetrating the fifth insulating layer; and
an encapsulation layer covering the light emitting element layer.

12. A display device comprising:
a capacitor comprising a first electrode provided in a first conductive layer on a substrate, a second electrode provided in a second conductive layer on the first conductive layer, a third electrode provided in a third conductive layer on the second conductive layer and a fourth electrode provided in a fourth conductive layer on the third conductive layer;
a first insulating layer disposed between the first conductive layer and the second conductive layer;
a second insulating layer disposed between the second conductive layer and the third conductive layer; and
a third insulating layer disposed between the third conductive layer and the fourth conductive layer,
wherein the fourth electrode is directly connected to the first electrode through a first contact hole penetrating the first insulating layer, the second insulating layer, and the third insulating layer, and directly connected to the third electrode through a second contact hole penetrating the third insulating layer.

13. The display device of claim 12, wherein the capacitor further comprises a fifth electrode spaced apart from the fourth electrode, provided in the fourth conductive layer, and overlapping the second electrode, and
the fifth electrode is directly connected to the second electrode through a third contact hole penetrating the second insulating layer and the third insulating layer.

14. The display device of claim 13, further comprising:
a fourth insulating layer disposed on the third insulating layer, and covering the fourth conductive layer; and
a fifth conductive layer disposed on the fourth insulating layer,
wherein the capacitor further comprises a sixth electrode provided in the fifth conductive layer and connected to the fifth electrode through a fourth contact hole penetrating the fourth insulating layer.

15. The display device of claim 12, further comprising:
a semiconductor layer disposed between the second insulating layer and the third conductive layer;
a gate insulating layer disposed between the semiconductor layer and the third conductive layer; and
a transistor comprising an active layer provided in the semiconductor layer, and a gate electrode provided in the third conductive layer and disposed on a part of the active layer.

16. The display device of claim 15, wherein the gate insulating layer is disposed between the part of the active layer and the gate electrode, and exposes another part of the active layer.

17. A method for manufacturing a display device, comprising:
forming a first conductive layer comprising a first electrode and a first insulating layer covering the first conductive layer, on a substrate;
forming a second conductive layer comprising a second electrode and a second insulating layer covering the second conductive layer, on the first insulating layer;
forming a semiconductor layer comprising an active layer of a transistor and a gate insulating layer covering the semiconductor layer, on the second insulating layer;
forming a conductive film on the gate insulating layer;
etching the conductive film and the gate insulating layer to form a first gate insulating layer and a gate electrode on a part of the active layer, and form a second gate insulating layer and a third electrode on a part of the second insulating layer;
forming a third insulating layer covering the active layer, the gate electrode, and the third electrode, on the second insulating layer;
forming a first contact hole penetrating the first insulating layer, the second insulating layer, and the third insulating layer to expose a part of the first electrode; and
forming a fourth conductive layer comprising a fourth electrode directly connected to the first electrode through the first contact hole, on the third insulating layer.

18. The method of claim 17, wherein the forming of the first contact hole comprises further forming a second contact hole penetrating the third insulating layer to expose a part of the third electrode, and
the forming of the fourth conductive layer comprises directly connecting the fourth electrode to the third electrode through the second contact hole.

19. The method of claim 17, wherein the forming of the first contact hole comprises further forming a third contact hole penetrating the second insulating layer and the third insulating layer to expose a part of the second electrode, and
the forming of the fourth conductive layer comprises further forming a fifth electrode spaced apart from the fourth electrode and directly connected to the second electrode through the third contact hole.

20. The method of claim 17, wherein the forming of the first contact hole comprises further forming a plurality of contact holes penetrating the third insulating layer to expose different parts of the active layer, and
the forming of the fourth conductive layer comprises further forming a source electrode and a drain electrode connected to different parts of the active layer through the plurality of contact holes.
